# EUROPEAN PATENT APPLICATION

(11) **EP 2 804 222 A1**
(43) Date of publication of application: **19.11.2014**
(21) Application number: 12865015.7
(22) Date of filing: 28.12.2012
(51) Int. Cl.: H01L 31/042, B60R 16/04

(54) **SOLAR CELL MODULE FOR IN-VEHICLE USE**

(30) Priority: 13.01.2012 JP 2012005073; 25.04.2012 JP 2012100120
(71) Applicant: Sanyo Electric Co., Ltd., Osaka 570-8677 (JP)
(72) Inventor: KURAMOTO, Keiichi, Moriguchi City Osaka 570-8677 (JP); KANEKO, Tetsuya, Moriguchi City Osaka 570-8677 (JP); KANNOU, Hiroyuki, Moriguchi City Osaka 570-8677 (JP); YANO, Hirofumi, Moriguchi City Osaka 570-8677 (JP)
(74) Representative: Glawe, Delfs, Moll
(86) International application number: PCT/JP2012/084142
(87) International publication number: WO 2013/105472

(57) **Abstract**

A solar cell module for in-vehicle use includes a first terminal, a second terminal, solar cell units, and a diode. Solar cell units are electrically connected in parallel between the first terminal and the second terminal and each includes solar cells electrically connected in series. A diode is electrically connected between the first terminal and the second terminal in parallel with the solar cell units, and configured to allow a current to substantially flow therethrough when a reverse bias voltage of the solar cell units exceeds a predetermined voltage value.

## Description

### TECHNICAL FIELD

The invention relates to a solar cell module for in-vehicle use.

### BACKGROUND ART

Recently, solar cell modules have attracted attention as an energy source with low environmental loads. Solar cell modules can be easily mounted on, for example, vehicles such as automobiles, because solar cell modules do not require fuel and are small in thickness.

Since solar cell modules attached to buildings such as houses and solar cell modules mounted on vehicles are used in different environments, for example, required characteristics are different between these solar cell modules. In view of this, for example, Patent Document 1 describes an example of a solar cell module suitable for in-vehicle use.

### PRIOR ART DOCUMENT

### PATENT DOCUMENT

Patent Document 1: Japanese Patent Application Publication No. 2009-295615

### SUMMARY OF THE INVENTION

### PROBLEM TO BE SOLVED BY THE INVENTION

Recently, there has been a demand for further improvement in fuel-efficiency of vehicles. With this, there has been a strong demand for a solar cell module which can be more suitably used as that for in-vehicle use.

A major object of the invention is to provide a solar cell module which can be suitably used as that for in-vehicle use, for example.

### MEANS FOR SOLVING THE PROBLEM

A solar cell module for in-vehicle use according to the invention includes a first terminal, a second terminal, solar cell units, and a diode. Each of the solar cell units includes solar cells electrically connected in series. The solar cell units are electrically connected in parallel between the first terminal and the second terminal. The diode is electrically connected between the first terminal and the second terminal in parallel with the solar cell units. The diode allows a current to substantially flow therethrough when a reverse bias voltage of the solar cell units exceeds a predetermined voltage value.

### EFFECTS OF THE INVENTION

The invention makes it possible to provide a solar cell module which can be suitably used as that for in-vehicle use, for example.

### BRIEF DESCRIPTION OF THE DRAWINGS

[Fig. 1] Fig. 1 is a schematic diagram of a solar cell module for in-vehicle use according to a first embodiment.
[Fig. 2] Fig. 2 is a connection diagram of the solar cell module for in-vehicle use according to the first embodiment and a secondary battery.
[Fig. 3] Fig. 3 is a schematic diagram of a solar cell module for in-vehicle use according to a second embodiment.
[Fig. 4] Fig. 4 is an equivalent circuit diagram of the solar cell module for in-vehicle use according to the second embodiment.
[Fig. 5] Fig. 5 is a schematic diagram of a solar cell module for in-vehicle use according to a third embodiment.
[Fig. 6] Fig. 6 is an equivalent circuit diagram of a solar cell module for in-vehicle use according to a fourth embodiment.
[Fig. 7] Fig. 7 is an equivalent circuit diagram of a solar cell module for in-vehicle use according to a fifth embodiment.
[Fig. 8] Fig. 8 is a schematic circuit diagram of a solar cell module for in-vehicle use according to a sixth embodiment.
[Fig. 9] Fig. 9 is a schematic plan view of the solar cell module for in-vehicle use according to the sixth embodiment.
[Fig. 10] Fig. 10 is a schematic perspective bottom view of the solar cell module for in-vehicle use according to the sixth embodiment.
[Fig. 11] Fig. 11 is a schematic cross-sectional view of solar cells of the sixth embodiment.
[Fig. 12] Fig. 12 is a schematic plan view of a solar cell module for in-vehicle use according to a reference example.
[Fig. 13] Fig. 13 is a schematic cross-sectional view of a solar cell module for in-vehicle use according to a modification of the sixth embodiment.

### MODES FOR CARRYING OUT THE INVENTION

Hereinafter, an example of preferred embodiments carrying out the invention is described. Note, however, that the following embodiments are for exemplary purposes only. The invention is not limited to the following embodiments at all.

In addition, in the drawings referred to in the embodiments and the like, members with substantially the same functions are denoted by the same reference signs. In addition, the drawings referred to in the embodiments and the like are schematic, and the ratios of dimensions and the like of objects illustrated in the drawings may be different from actual ones. The ratios of dimensions and the like of objects may vary among the drawings. The specific ratios of dimensions and the like of objects should be determined in consideration of the following description.

### (First Embodiment)

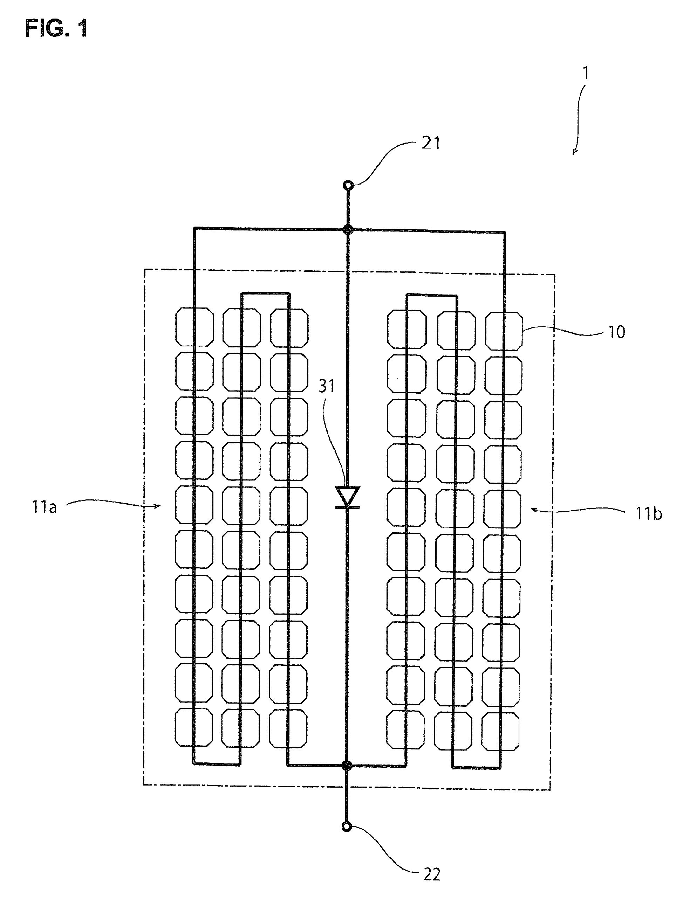

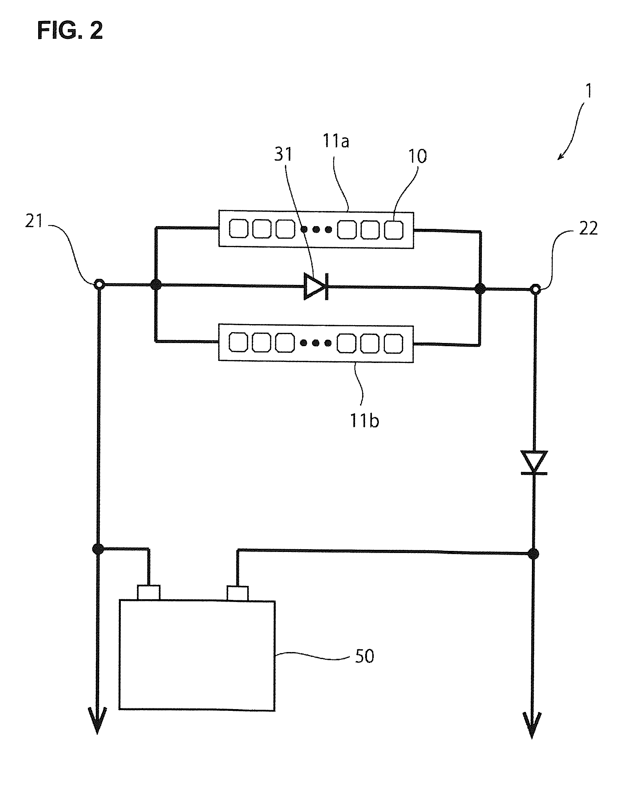

Fig. 1 is a schematic diagram of solar cell module 1 for in-vehicle use according to a first embodiment. Fig. 2 is a connection diagram between solar cell module 1 for in-vehicle use according to the first embodiment and a secondary battery.

Solar cell module 1 for in-vehicle use is a solar cell module for in-vehicle use. Solar cell module 1 for in-vehicle use is used, for example, by being attached to a roof, a door, or the like of a vehicle such as an automobile or an electric train. Solar cell module 1 for in-vehicle use may constitute a part of a roof, a door, or the like of a vehicle. A shape of solar cell module 1 for in-vehicle use may be rectangular, or may be a shape other than a rectangular shape, such as an arch shape, for example.

Solar cell module 1 for in-vehicle use includes first terminal 21, second terminal 22, and solar cells 10. The type of solar cells 10 is not particularly limited. Solar cells 10 may be, for example, crystalline silicon solar cells, thin film solar cells, compound semiconductor solar cells, or the like. In addition, solar cells 10 may be solar cells configured to generate electric power only upon reception of light on one principal surface, or bifacial solar cells configured to generate electric power upon reception of light on any of the principal surfaces.

Solar cells 10 are disposed in a bonding layer disposed between a first protective member and a second protective member. For example, the first protective member may be made of a glass plate, a resin plate, or the like, and the second protective member may be made of a resin sheet or the like. Alternatively, both the first protective member and the second protective member may be made of glass plates or resin plates. The bonding layer can be made of, for example, a cross-linked resin such as ethylene-vinyl acetate copolymer (EVA), a non-cross-linked resin such as a polyolefin, or the like.

Solar cells 10 are included in solar cell units 11a and 11b. Specifically, solar cell module 1 for in-vehicle use includes two solar cell units 11a and 11b. In each of solar cell units 11a and 11b, solar cells 10 are electrically connected in series. The number of solar cells 10 in each of solar cell units 11a and 11b is not particularly limited, as long as the number is 2 or more. Each of solar cell units 11a and 11b may include three or more solar cells 10.

Solar cell units 11a and 11b are electrically connected in parallel between first terminal 21 and second terminal 22.

Diode 31 is connected between first terminal 21 and second terminal 22. Diode 31 is electrically connected in parallel with solar cell units 11a and 11b. Diode 31 is designed to allow a current to substantially flow therethrough when a reverse bias voltage of solar cell units 11a and 11b exceeds a predetermined voltage value.

As illustrated in Fig. 2, solar cell module 1 for in-vehicle use is used, for example, by being directly electrically connected to secondary battery 50 mounted on a vehicle without a converter. When solar cell module 1 for in-vehicle use is irradiated with light, solar cell module 1 for in-vehicle use charges secondary battery 50. In this case, in order for solar cell module 1 for in-vehicle use to charge secondary battery 50, the voltage generated by solar cell module 1 for in-vehicle use need to exceed the voltage of secondary battery 50. For this reason, solar cell module 1 for in-vehicle use is designed so that such a voltage relationship can be satisfied when solar cell module 1 for in-vehicle use is irradiated with light. Specifically, for example, solar cell module 1 for in-vehicle use is designed so that the value obtained by multiplying an electromotive force per solar cell 10 by the number of solar cells 10 included in each of solar cell units 11a and 11b can exceed the voltage of secondary battery 50. In general, considering the light irradiation state of solar cell module 1 for in-vehicle use, solar cell module 1 for in-vehicle use is designed so that the value obtained by multiplying the operation voltage per solar cell 10 by the number of solar cells 10 included in each of solar cell units 11a and 11b can exceed, for example, 1.2 times of the voltage of secondary battery 50.

Incidentally, for example, when a solar cell module is installed on a house or the like, the solar cell module is installed on a roof or the like so as not to allow the presence of any obstacle to the irradiation of the solar cell module with light. Hence, it is rare that an unexpectedly large shadow which greatly lowers the out-put of solar cell module 1 for in-vehicle use falls on the solar cell module.

In contrast, a vehicle travels in unspecified sites. For this reason, depending on the traveling situation or the like, it is often that a shadow falls on the solar cell module mounted on a vehicle, so that the solar cell module does not charge the secondary battery. Hence, it is necessary to obtain stable out-put even when a shadow falls on the solar cell module, so that the solar cell module can charge the secondary battery stably. Such an object is unique to solar cell modules for in-vehicle use, and absent in solar cell module installed on real estate such as houses.

Here, for example, when a shadow falls on some solar cells in a solar cell module in which all solar cells are connected in series, the solar cells on which the shadow falls do not generate electric power, and further act as resistance components. Hence, the out-put of the solar cell module greatly decreases. As a result, the solar cell module tends not to charge the secondary battery.

In contrast, in solar cell module 1 for in-vehicle use, first, solar cell units 11a and 11b each including solar cells 10 electrically connected in series are electrically connected in parallel. Moreover, diode 31 is connected in parallel with solar cell units 11a and 11b. For this reason, for example, when the voltage of one of solar cell units 11a and 11b decreases because of a shadow falling on some solar cells 10 included in the one of solar cell units 11a and 11b, the charging by the electric power of the one of solar cell units 11a and 11b becomes insufficient. However, the other one of solar cell units 11a and 11b supplies an electric power with a higher voltage than the voltage of secondary battery 50. Hence, the secondary battery 50 continues to be charged. In other words, in solar cell module 1 for in-vehicle use, the secondary battery 50 continues to be charged, unless such a large shadow that the voltages of solar cell units 11a and 11b become equal to or lower than the voltage of secondary battery 50 falls on all solar cell units 11a and 11b. Hence, the use of solar cell module 1 for in-vehicle use makes it possible to efficiently supply electric power also to secondary battery 50 mounted on a moving vehicle.

Note that diode 31 may include one diode or diodes electrically connected in series or in parallel. In such a case, a connection point of adjacent diodes and a connection point of adjacent solar cells may be electrically connected to each other.

Another example of a preferred embodiment of the invention is described below. In the following description, members having substantially the same functions as in the above-described first embodiment are denoted by the same reference signs, and description thereof is omitted.

### (Second Embodiment)

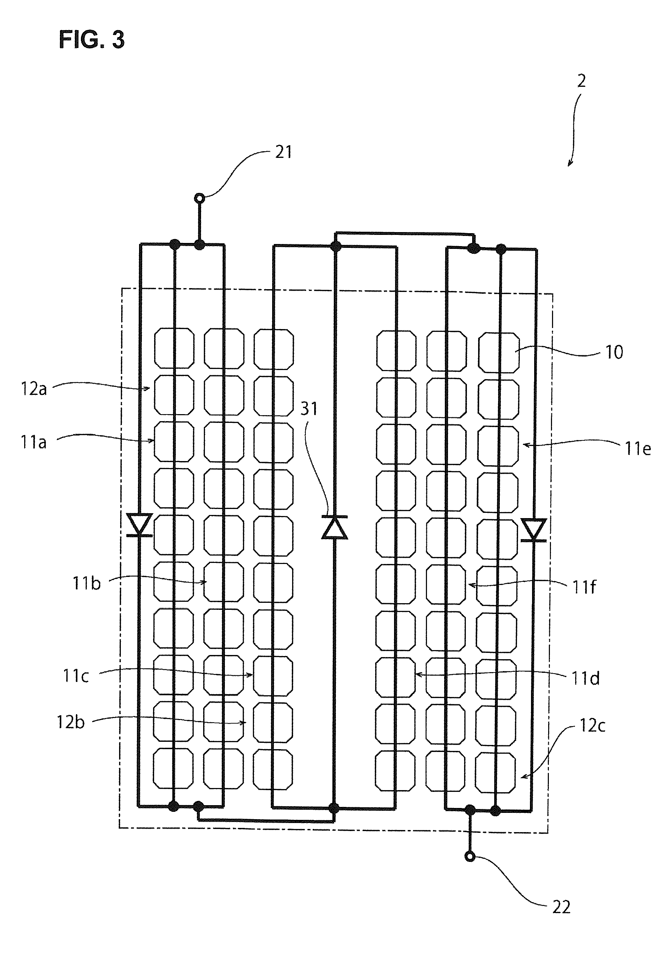

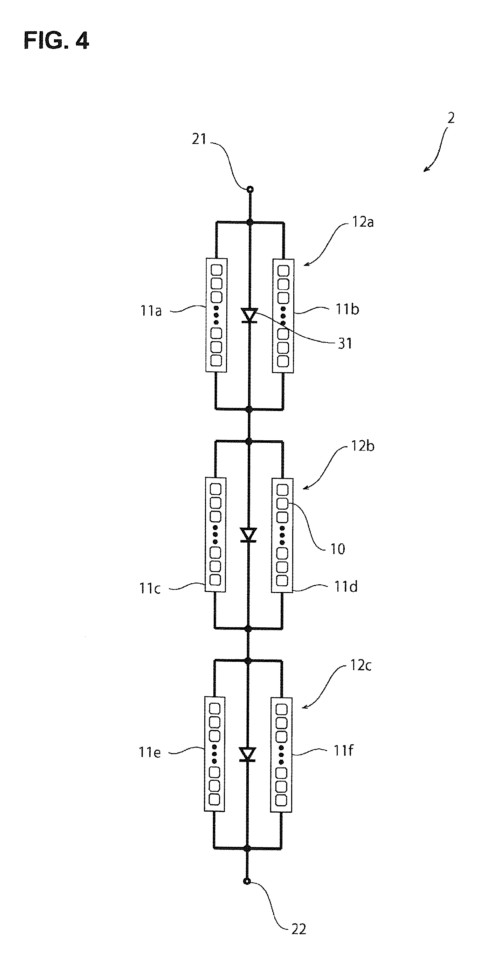

Fig. 3 is a schematic diagram of solar cell module 2 for in-vehicle use according to a second embodiment. Fig. 4 is an equivalent circuit diagram of solar cell module 2 for in-vehicle use according to the second embodiment.

In solar cell module 2 for in-vehicle use, circuits 12a, 12b, and 12c, in which solar cell units 11a to 11f and diodes 31 are electrically connected in parallel, are connected in series between first terminal 21 and second terminal 22. In solar cell module 2 for in-vehicle use, as long as at least one of solar cell units 11a and 11b included in circuit 12a, at least one of solar cell units 11c and 11d included in circuit 12b, and at least one of solar cell units 11e and 11f included in circuit 12c contribute to the electric power generation, the voltage of solar cell module 2 for in-vehicle use exceeds the voltage of secondary battery 50, and hence secondary battery 50 continues to be charged. For this reason, secondary battery 50 continues to be charged, even when a shadow falls on one of solar cell units 11a and 11b included in circuit 12a, one of solar cell units 11c and 11d included in circuit 12b, and one of solar cell units 11e and 11f included in circuit 12c. Hence, the use of solar cell module 2 for in-vehicle use also makes it possible to efficiently supply electric power to secondary battery 50 mounted on a moving vehicle.

### (Third embodiment)

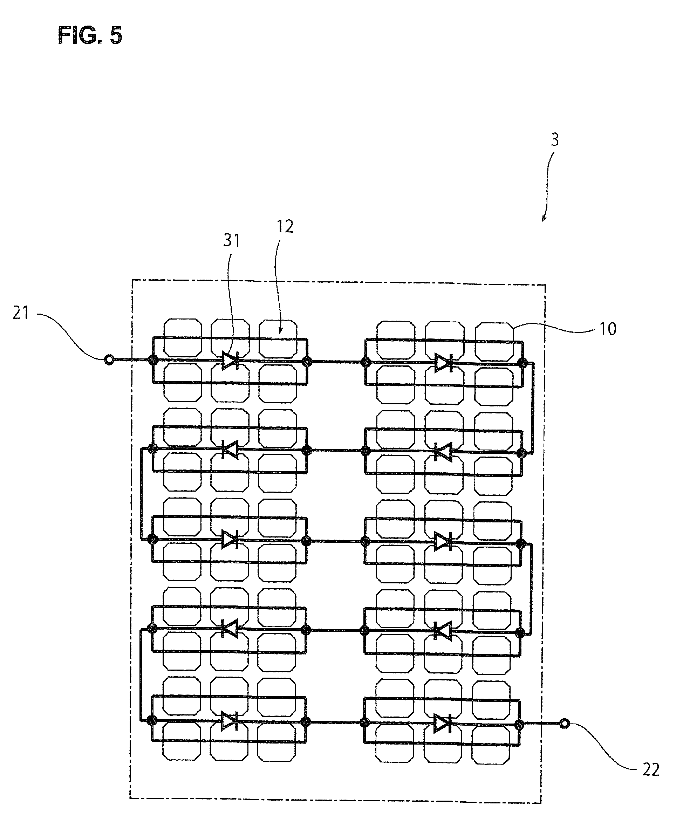

Fig. 5 is a schematic diagram of solar cell module 3 for in-vehicle use according to a third embodiment. In solar cell module 3 for in-vehicle use, four or more, specifically, ten circuits 12, in each of which solar cell units and diode 31 are electrically connected in parallel, are electrically connected in series between first terminal 21 and second terminal 22. In solar cell module 3 for in-vehicle use, as long as at least one of the two solar cell units included in each circuit 12 contributes to the electric power generation, the voltage of solar cell module 3 for in-vehicle use exceeds the voltage of secondary battery 50, and hence secondary battery 50 continues to be charged. Hence, the use of solar cell module 3 for in-vehicle use also makes it possible to efficiently supply electric power to secondary battery 50 mounted on a moving vehicle.

### (Fourth Embodiment)

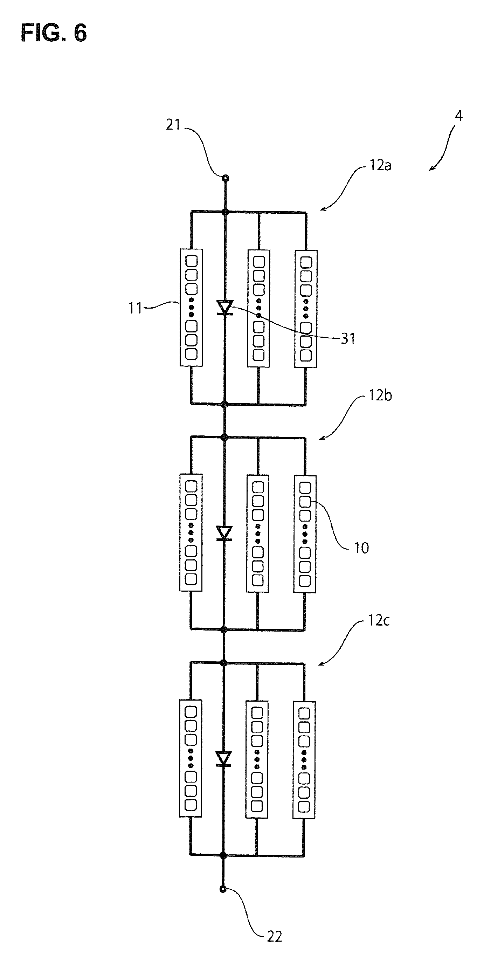

Fig. 6 is an equivalent circuit diagram of solar cell module 4 for in-vehicle use according to a fourth embodiment.

In the case of solar cell module 2 for in-vehicle use, an example where two solar cell units and diode 31 are connected in parallel in each of circuits 12a to 12c as illustrated in Fig. 4 is described. On the other hand, in solar cell module 4 for in-vehicle use, three or more solar cell units 11 and diode 31 are connected in parallel in each of circuits 12a to 12c. For this reason, in solar cell module 4 for in-vehicle use, even when a shadow falls on two solar cell units 11 included in each of circuits 12a to 12c, the voltage of solar cell module 4 for in-vehicle use exceeds the voltage of secondary battery 50, and hence secondary battery 50 continues to be charged. Hence, the use of solar cell module 4 for in-vehicle use also makes it possible to efficiently supply electric power to secondary battery 50 mounted on a moving vehicle.

### (Fifth Embodiment)

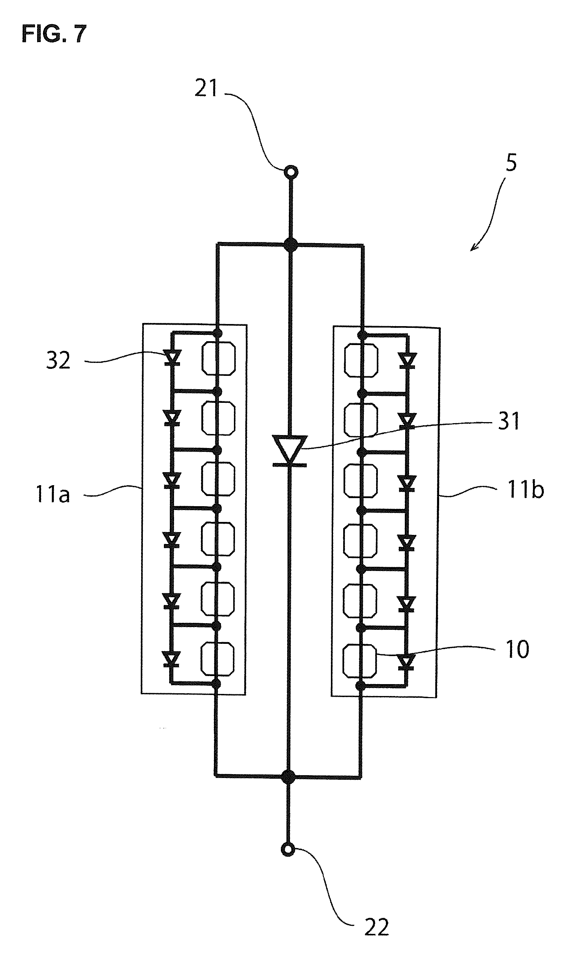

Fig. 7 is an equivalent circuit diagram of solar cell module 5 for in-vehicle use according to a fifth embodiment. In solar cell module 5 for in-vehicle use, at least one of solar cell units 11a and 11b includes diode 32 electrically connected in parallel with at least one of solar cells 10. Specifically, diodes 32 are electrically connected to solar cells 10, respectively. A current substantially flows through diode 32, when a reverse bias voltage of the at least one solar cell 10 electrically connected in parallel with diode 32 exceeds a predetermined voltage value. In other words, a current substantially flows through diode 32, when solar cell 10 connected in parallel with diode 32 is not generating electric power. Meanwhile, when solar cell 10 is generating electric power, substantially no current flows through diode 32.

Since diodes 32 are provided in solar cell module 5 for in-vehicle use, it is possible to effectively reduce the decrease in electric power generated by solar cell units 11a and 11b occurring when a shadow falls on some of solar cells 10 in solar cell units 11a and 11b, and the solar cells 10 do not contribute to the electric power generation. Hence, the use of solar cell module 5 for in-vehicle use makes it possible to efficiently supply electric power to secondary battery 50 mounted on a moving vehicle.

### (Sixth Embodiment)

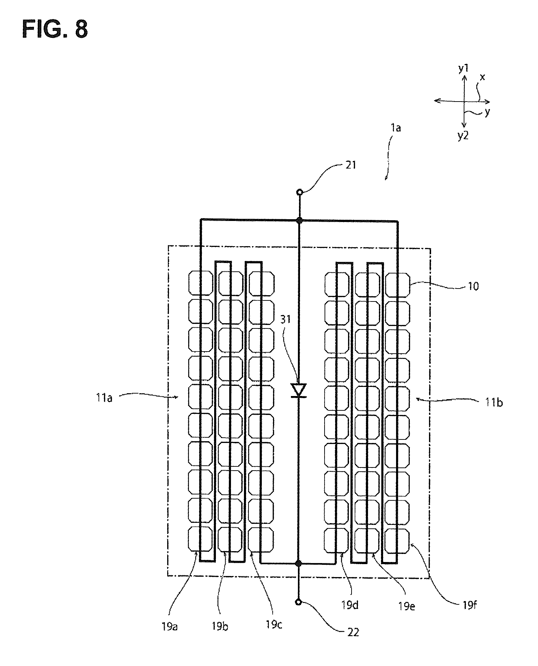

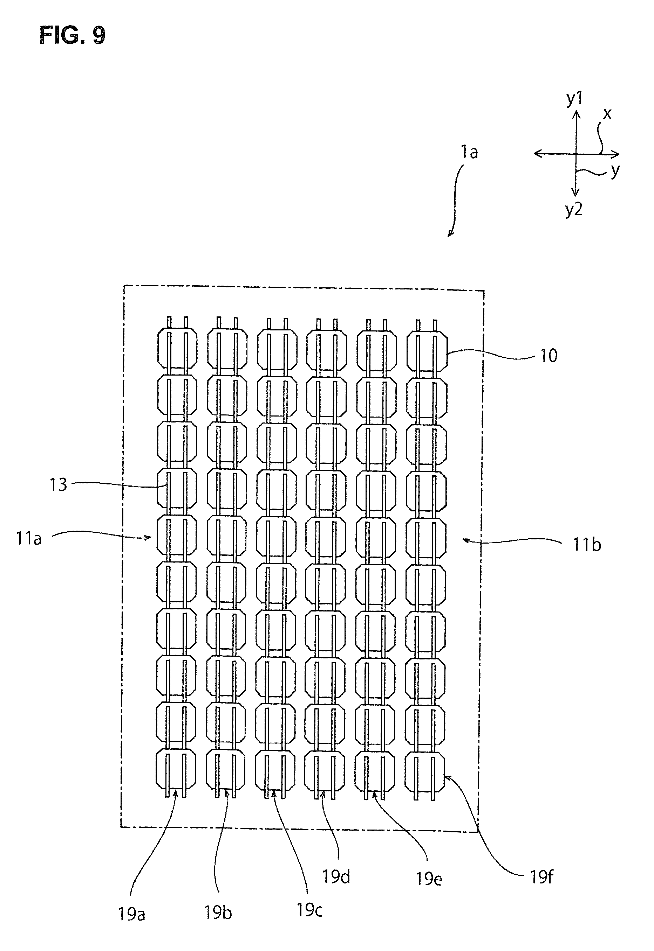

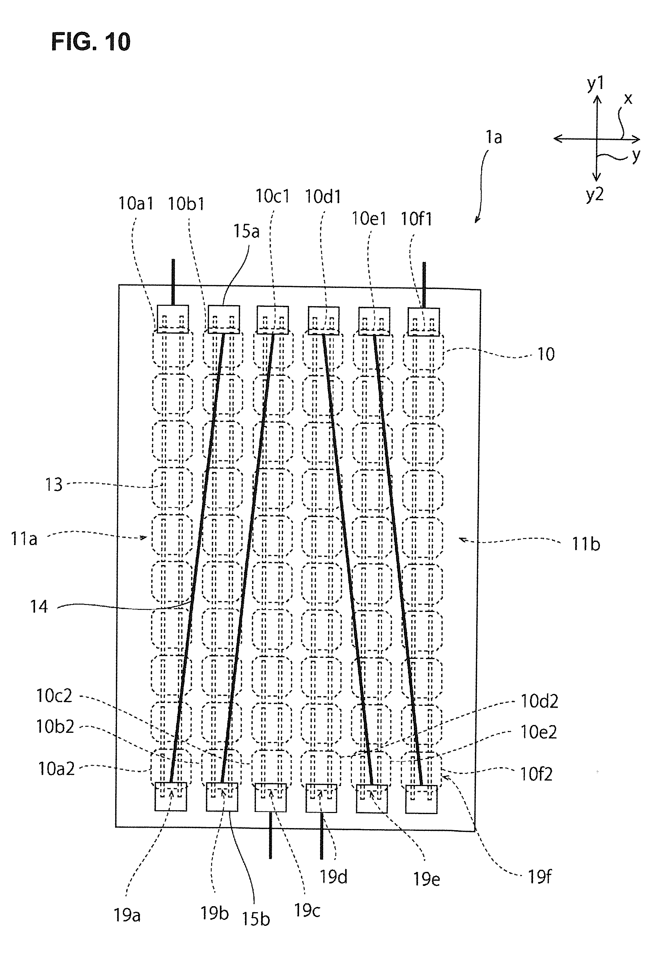

Fig. 8 is a schematic circuit diagram of a solar cell module for in-vehicle use according to this embodiment. Fig. 9 is a schematic plan view of the solar cell module for in-vehicle use according to this embodiment. Fig. 10 is a schematic perspective bottom view of the solar cell module for in-vehicle use according to this embodiment.

Solar cell module 1a for in-vehicle use is a solar cell module for in-vehicle use. Solar cell module 1a for in-vehicle use is used, for example, by being attached to a roof, a door, or the like of a vehicle such as an automobile or an electric train. Solar cell module 1a for in-vehicle use may constitute a part of a roof, a door, or the like of a vehicle. A shape of solar cell module 1a for in-vehicle use may be rectangular, or may be a shape other than a rectangular shape, such as an arch shape, for example.

Solar cell module 1a for in-vehicle use includes first terminal 21 and second terminal 22. Solar cell units 11a and 11b are electrically connected in parallel between first terminal 21 and second terminal 22. Of course, the solar cell module may include only one solar cell unit.

Solar cell unit 11a includes solar cell strings 19a to 19c. Solar cell strings 19a to 19c are arranged in an x-axis direction (another direction). Solar cell unit 11b includes solar cell strings 19d to 19f. Solar cell strings 19d to 19f are arranged in the x-axis direction (the other direction). Note that unillustrated diodes may be electrically connected in parallel with solar cell strings 19d to 19f, respectively. Each of the diodes is designed to allow a current to substantially flow therethrough when the reverse bias voltage of the corresponding one of the solar cell strings 19d to 19f exceeds a predetermined voltage value.

Each of solar cell strings 19a to 19c includes solar cells 10. In each of solar cell strings 19a to 19c, solar cells 10 are arranged in a y-axis direction (one direction). In each of solar cell strings 19a to 19c, solar cells 10 are electrically connected by wiring members 13 (see Figs. 9 and 10). Specifically, in each of solar cell strings 19a to 19c, solar cells 10 are electrically connected in series by wiring members 13.

Solar cell strings 19a to 19c included in first solar cell unit 11a are electrically connected in series by wiring members 14 (see Fig. 10). Solar cell strings 19d to 19f included in second solar cell unit 11b are electrically connected in series by wiring members 14. Specifically, each of solar cell strings 19a to 19f is provided with terminal boxes 15a and 15b on both sides thereof. Each wiring member 14 electrically connects terminal box 15a to terminal box 15b, so that solar cell strings 19a to 19c and 19d to 19f included in solar cell units 11a are electrically connected in series.

The electrical connection direction is the same among solar cell strings 19a to 19c. Specifically, the direction from solar cell 10 on a positive electrode side to solar cell 10 on a negative electrode side is the same among solar cell strings 19a to 19c. In other words, the direction from solar cell 10 with a highest electric potential to solar cell 10 with a lowest electric potential is the same among solar cell strings 19a to 19c. For this purpose, in each of first and second solar cell units 11a and 11b, each wiring member 14 electrically connects solar cell 10 included in one of each two of the solar cell strings adjacent in the x-axis direction and positioned in an end portion on one side (y1 side) in the y-axis direction to solar cell 10 included in the other solar cell string and positioned in an end portion of the other side (y2 side) in the y-axis direction.

Specifically, solar cell 10a2 positioned on the most y2 side in solar cell string 19a and solar cells 10b1 positioned on the most y1 side in solar cell string 19b adjacent to solar cell string 19a in the x-axis direction are electrically connected by wiring member 14. Solar cell 10b2 positioned on the most y2 side in solar cell string 19b and solar cell 10c1 positioned on the most y1 side in solar cell string 19c adjacent to solar cell string 19b in the x-axis direction are electrically connected by wiring member 14. Solar cell 10f2 positioned on the most y2 side in solar cell string 19f and solar cell 10e1 positioned on the most y1 side in solar cell string 19e adjacent to solar cell string 19f in the x-axis direction are electrically connected by wiring member 14. Solar cell 10e2 positioned on the most y2 side in solar cell string 19e and solar cell 10d1 positioned on the most y1 side in solar cell string 19d adjacent to solar cell string 19e in the x-axis direction are electrically connected by wiring member 14. Solar cells 10a1 and 10f1 positioned on the most y1 side in solar cell strings 19a and 19f are electrically connected to first terminal 21. Solar cells 10c2 and 10d2 positioned on the most y2 side in solar cell strings 19c and 19d are electrically connected to second terminal 22.

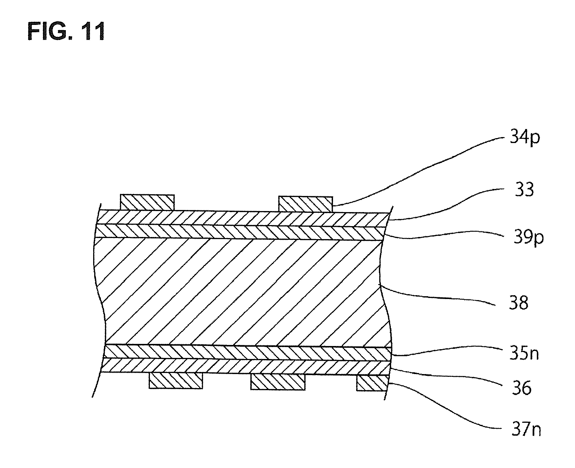

The type of solar cells 10 is not particularly limited, and crystalline solar cells, back junction solar cells, and the like can be used. As illustrated in Fig. 11, each solar cell 10 includes substrate 38 in this embodiment. Substrate 38 is made of a semiconductor material. Substrate 38 is preferably made of a crystalline semiconductor material. Substrate 38 is more preferably made of a single crystalline semiconductor material. Specifically, substrate 38 can be made of, for example, a single crystalline silicon substrate or a polycrystalline silicon substrate.

A rugged structure called a texture structure is provided on at least one principal surface of substrate 38. Here, the "texture structure" refers to a rugged structure formed to reduce surface reflection and thus increase the amount of light absorbed by substrate 38. A specific example of the texture structure is a rugged structure of pyramid shapes (quadrangular pyramid shapes or quadrangular pyramidal frustum shapes) obtained by performing anisotropic etching on a surface of a single crystalline silicon substrate including (100) plane.

p-Type semiconductor layer 39p is disposed on one principal surface of substrate 38. p-Type semiconductor layer 39p can be made of, for example, p-type amorphous silicon. A substantially intrinsic i-type semiconductor layer with such a thickness that the semiconductor layer does not substantially contribute to the electric power generation may be provided between p-type semiconductor layer 39p and substrate 38. The i-type semiconductor layer can be made of, for example, i-type amorphous silicon.

A transparent conducting oxide film 33 as a translucent or transparent film is disposed on p-type semiconductor layer 39p. Transparent conducting oxide film 33 can be made of, for example, indium tin oxide (ITO) or the like.

p-Side electrode 34p is disposed on transparent conducting oxide film 33.

n-Type semiconductor layer 35n is disposed on the other principal surface of substrate 38. n-Type semiconductor layer 35n can be made of, for example, n-type amorphous silicon. A substantially intrinsic i-type semiconductor layer with such a thickness that the semiconductor layer does not substantially contribute to the electric power generation may be provided between n-type semiconductor layer 35n and substrate 38. The i-type semiconductor layer can be made of, for example, i-type amorphous silicon.

A transparent conducting oxide film 36 as a translucent or transparent film is disposed on n-type semiconductor layer 35n. Transparent conducting oxide film 36 can be made of, for example, indium tin oxide (ITO) or the like.

n-Side electrode 37n is disposed on transparent conducting oxide film 36.

Although not illustrated, solar cells 10 are disposed in a bonding layer disposed between a first protective member and a second protective member. For example, the first protective member may be made of a glass plate, a resin plate, or the like, and the second protective member may be made of a resin sheet or the like. Alternatively, both the first protective member and the second protective member may be made of glass plates or resin plates. The bonding layer can be made of, for example, a cross-linked resin such as ethylene-vinyl acetate copolymer (EVA), a non-cross-linked resin such as a polyolefin, or the like.

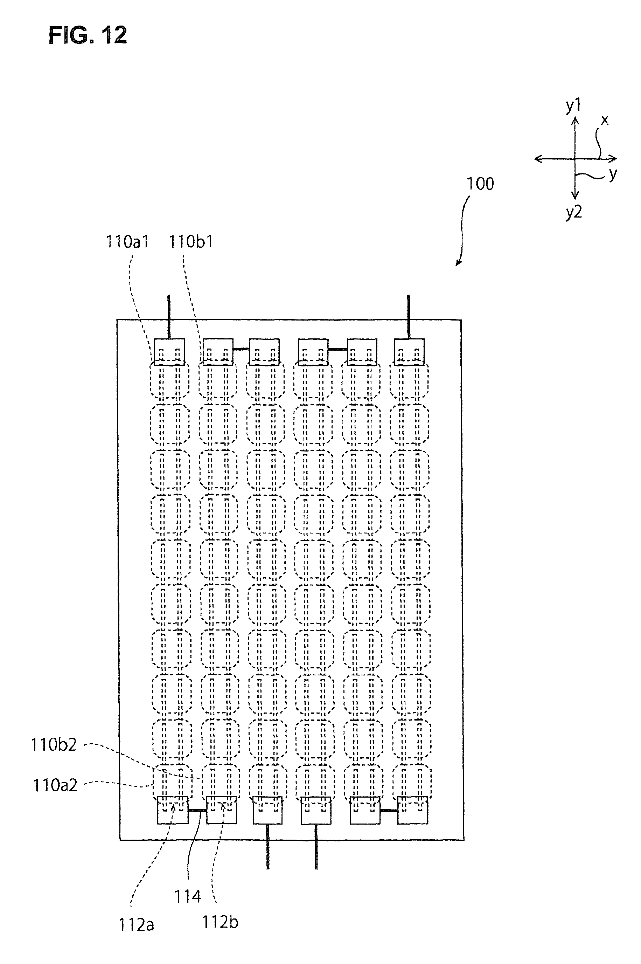

Here, from the viewpoint of, for example, simplifying the structure of the solar cell module or reducing resistance loss in the solar cell module, it is generally believed that the length of the wiring member electrically connecting solar cell strings to each other is preferably short. Hence, as illustrated in Fig. 12, for example, it is conceivable that adjacent solar cells 110a2 and 110b2 are electrically connected by wiring member 114 for electrically connecting adjacent solar cell strings 112a and 112b. However, in this case, the potential difference between adjacent solar cell 110a1 and solar cell 110b1 is large. Hence, to reliably insulate solar cells 110a1 and 110b1 from each other, the space between solar cell string 112a and solar cell string 112b has to be wide. Hence, the size of the solar cell module 100 increases.

On the other hand, in each of first and second solar cell units 11a and 11b in solar cell module 1a, each wiring member 14 electrically connects solar cell 10 included in one of each two of the solar cell strings adjacent in the x-axis direction and positioned in an end portion on one side (y1 side) in the y-axis direction to solar cell 10 included in the other solar cell string and positioned in an end portion on the other side (y2 side) in the y-axis direction. For this reason, the potential difference is small between the one solar cell 10 in the one of the adjacent solar cell strings and solar cell 10 belonging to the other solar cell string and being adjacent to the one solar cell 10 in the x-axis direction. Hence, a low resistance value is required between the adjacent solar cell strings in the x-axis direction for insulating the solar cell strings from each other. Therefore, the distance between the adjacent solar cell strings can be short. Accordingly, the size of the solar cell module 1a can be reduced.

In addition, the area ratio of regions where solar cells 10 are provided can be increased in solar cell module 1a. Hence, solar cell module 1a with improved output characteristics can be achieved. In sum, solar cell module 1a with a small size and improved output characteristics can be achieved.

Here, the color of some types of solar cells varies depending on the viewing direction. For example, as in the case of this embodiment, in a case where solar cell 10 includes substrate 38 made of a crystalline semiconductor material, a case where translucent or transparent films such as transparent conducting oxide films 33 and 36 are provided on the principal surfaces of substrate 38, a case where an optically functional rugged structure such as a texture structure is provided on a principal surface of substrate 38, or other cases, the color of solar cell 10 tends to vary depending on the viewing direction. For example, when substrate 38 is made of a single crystalline semiconductor material, the change in color of solar cell 10 tends to be visually recognized.

In the case of solar cell module 100 illustrated in Fig. 12, the electrical connection directions are opposite between adjacent solar cell strings. Hence, the adjacent solar cell strings are visually recognized in different colors in some cases. Hence, a striped pattern is visually recognized on solar cell module 100 in some cases.

In contrast, in solar cell module 1a, the electrical connection direction is the same among solar cell strings 19a to 19f. Hence, the visually recognized colors are similar among solar cell strings 19a to 19f. Therefore, solar cell module 1a is provided with an excellent appearance.

In solar cell module 1a, the electrical connection direction is the same among solar cell strings 19a to 19f. For this purpose, one end portion (on the y1 side) of each wiring member 13 in the y-axis direction of a solar cell string is connected to the light-receiving surface side of one solar cell 10, while the other end portion (on the y2 side) is connected to the bottom side of another solar cell 10 adjacent to the one solar cell. Hence, wiring members 13 are arranged in the y-axis direction in the same pattern all over solar cell strings 19a to 19c. Hence, solar cell module 1a is provided with an excellent appearance.

Note that, to further improve the appearance of solar cell module 1a, the color of the portion where no solar cells 10 are provided viewed from the light-receiving surface side may be made the same as the color of solar cells 10 viewed from the light-receiving surface side. In this case, it is conceivable that a black second protective member is provided on the entire region where the first protective member is provided. However, since the second protective member is adhered to a vehicle for adhering the solar cell module to a vehicle, the solar cell module may undergo failure or fall off, if the protective member or the like peels off. In this respect, to increase the rigidity of the solar cell module for prevention of failure, it is preferable to use a second protective member having a smaller area than the first protective member, and provide an adhesion region to a vehicle around the first protective member.

In the case where the adhesion region is provided, a paint having the same color as that of solar cells 10, specifically a black insulating paint may be applied on the first protective member between the adhesion region and the second protective member. This makes it possible to not only facilitate the formation of the adhesion region, but also improve the appearance of the solar cell module, simultaneously. In addition, from the viewpoint of further improving the appearance of the solar cell module, an adhesive agent for adhering the solar cell module to a vehicle further preferably has the same color as that of the second protective member or the paint.

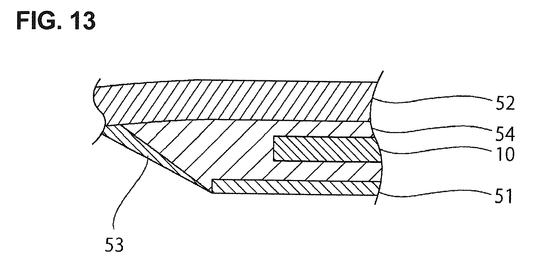

When paint 53 is applied between the adhesion region and the second protective member after the solar cells are fixed between the first protective member and the second protective member, as illustrated in Fig. 13, a surface of bonding layer 54 preferably has a tapered shape extending from a surface of the second protective member 51 to a surface of the first protective member 52. In addition, it is preferable that no staircase shape made of an end portion of the second protective member 51 or the like be formed on the first protective member 52. This makes it possible to prevent scattering of light in a specific direction at an end portion of the second protective member 51, so that the design of the solar cell module viewed from the light-receiving surface can be improved. Note that when the surface of bonding layer 54 is formed in a rugged shape, the appearance can be improved by further reducing the scattering of light, and the adhesion strength between bonding layer 54 and paint 53 can be increased.

The design can be improved by employing, for example, a configuration in which the adhesion region is provided only two edges of the first protective member 52 facing each other, and the other two edges are coated with paint 53 to the vicinity of the solar cells to make the wiring members 14 invisible through the light-receiving surface.

Note that, in this embodiment, the example is described in which terminal boxes 15a and 15b are provided on both sides of each of solar cell strings 19a to 19f, and wiring members 14 include cables which are provided outside the bonding layer and which connect terminal boxes 15a and 15b. However, the invention is not limited to this configuration. Wiring members 14 may be made of, for example, metal foils or a printed wiring board disposed in the bonding layer. Moreover, the terminal boxes do not necessarily have to be provided on both sides of all the solar cell strings. Furthermore, how to connect the solar cell is not particularly limited, either.

### EXPLANATION OF REFERENCE NUMERALS

- 1 to 5: solar cell module for in-vehicle use
- 10: solar cell
- 11, 11a to 11f: solar cell unit
- 12, 12a to 12c: circuit
- 13, 14: wiring member
- 15a, 15b: terminal box
- 19a to 19f: solar cell string
- 21: first terminal
- 22: second terminal
- 31: diode
- 32: diode
- 33, 36: transparent conducting oxide film
- 38: substrate made of semiconductor material
- 50: secondary battery

## Claims

1. A solar cell module for in-vehicle use, comprising:
a first terminal;
a second terminal;
solar cell units electrically connected in parallel between the first terminal and the second terminal and each including solar cells electrically connected in series; and
a diode electrically connected between the first terminal and the second terminal in parallel with the solar cell units, and configured to allow a current to substantially flow therethrough when a reverse bias voltage of the solar cell units exceeds a predetermined voltage value.

2. The solar cell module for in-vehicle use according to claim 1, wherein
sets each including the solar cell units electrically connected in parallel are electrically connected in series between the first terminal and the second terminal.

3. The solar cell module for in-vehicle use according to claim 1 or 2, wherein
at least one of the solar cell units further includes a diode electrically connected in parallel with at least one of the solar cells and configured to allow a current to substantially flow therethrough when a reverse bias voltage of the at least one solar cell exceeds a predetermined voltage value.

4. The solar cell module for in-vehicle use according to any one of claims 1 to 3, wherein
the solar cell units include
solar cell strings which each include two or more of the solar cells arranged in one direction and a first wiring member electrically connecting the two or more solar cells, and which are arranged in another direction, and
a second wiring member electrically connecting the solar cell strings in series, and
the second wiring member electrically connects a solar cell included in one of each two of the solar cell strings adjacent in the other direction and positioned in an end portion on one side in the one direction to a solar cell included in the other solar cell string and positioned in an end portion on another side in the one direction.

5. The solar cell module for in-vehicle use according to any one of claims 1 to 4, wherein
each of the solar cells includes a substrate made of a crystalline semiconductor material.

6. The solar cell module for in-vehicle use according to claim 5, wherein
the substrate is made of a single crystalline semiconductor material.

7. The solar cell module for in-vehicle use according to claim 5 or 6, wherein
each of the solar cells includes a translucent or transparent film disposed on a principal surface on a light-receiving surface side of the substrate.

8. The solar cell module for in-vehicle use according to any one of claims 5 to 7, wherein
at least one principal surface of the substrate is provided with a rugged structure.

9. The solar cell module for in-vehicle use according to any one of claims 4 to 8, wherein
an electrical connection direction is the same among the solar cell strings.
